# EUROPÄISCHE PATENTSCHRIFT

(11) **EP 1 547 334 B1**
(45) Veröffentlichungstag und Bekanntmachung des Hinweises auf die Patenterteilung: **14.03.2007**
(21) Anmeldenummer: 03798053.9
(22) Anmeldetag: 04.08.2003
(51) Int. Cl.: H04L 27/06

(54) **VERFAHREN UND SCHALTUNGSANORDNUNG ZUR DEMODULATION EINES DIGITALEN AMPLITUDENMODULIERTEN FUNKSIGNALS**
METHOD AND CIRCUIT ARRANGEMENT FOR DEMODULATING A DIGITAL AMPLITUDE-MODULATED RADIO SIGNAL
PROCEDE ET CIRCUITERIE POUR LA DEMODULATION D'UN SIGNAL RADIO NUMERIQUE MODULE EN AMPLITUDE

(30) Priorität: 24.09.2002 DE 10244450
(43) Veröffentlichungstag der Anmeldung: 29.06.2005
(73) Patentinhaber: Infineon Technologies AG, 81669 München (DE)
(72) Erfinder: ALIHODZIC, Admir, A-8010 Graz (AT)
(74) Vertreter: Epping - Hermann - Fischer
(86) Internationale Anmeldenummer: PCT/DE2003/002609
(87) Internationale Veröffentlichungsnummer: WO 2004/030300

(56) Entgegenhaltungen:
- WO-A-00/45329
- US-B1- 6 314 143

## Beschreibung

Die Erfindung betrifft ein Verfahren und eine Schaltungsanordnung zur Demodulation eines mit einer Empfangseinrichtung empfangenen digitalen amplitudenmodulierten Funksignals.

Kontaktlose Chipkarten, insbesondere RFID (radio frequency identification) Chipkarten erhalten über eine Funkstrecke nicht nur ein Nachrichtensignal, bestehend aus einem amplitudenmodelierten Funksignal, sondern entnehmen dem empfangenen Signal auch die für den Betrieb der Chipkarte notwendige Betriebsspannung.

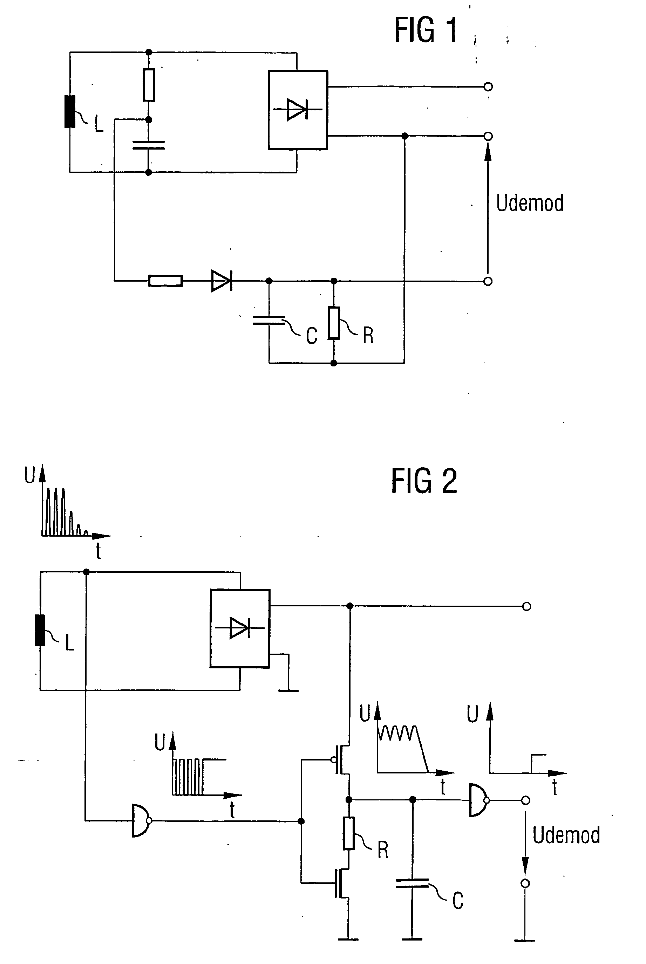

Wie in Figur 1 dargestellt und in RFID-Handbuch; Finkenzeller, K.; 2. Auflage beschrieben, verfügen zu diesem Zweck diese Chipkarten über eine Gleichrichtungseinrichtung, die mit zwei Ausgängen einer Empfangseinrichtung verbunden ist. Zusätzlich ist ein Ausgang der Empfangseinrichtung einer Demödulationseinrichtung zugeführt. Diese trennt ein empfangenes Trägersignal von dem enthaltenen Nachrichtensignal.

Zu diesem Zweck ist in der Demodulationseinrichtung ein RC-Glied angeordnet, mit der Aufgabe die Trägerfrequenz aus dem empfangenen Signal herauszufiltern. Die Dimensionierung des RC-Gliedes ist abhängig von der Frequenz des empfangenen Trägersignals und von dessen Amplitude. Damit sind die Abmessungen des RC-Gliedes gegebenenfalls groß und beanspruchen entsprechend viel Raum und Flächenanteil eines Chip für die kontaktlose Chipkarte.

Aus der Druckschrift US 6,314,143 B1 ist Verfahren und eine Schaltungsanordnung bekannt, bei der ein mit einer Empfangseinrichtung empfangenes digitales amplitudenmoduliertes Funksignal mit einem Trägersignal und einem diesen aufgeprägten Nachrichtensignal demoduliert wird.

Ein zumindest firmeninterner Stand der Technik ist in der in Figur 2 dargestellten Schaltungsanordnung beschrieben, wobei ein empfangenes Signal vor der Demodulation durch ein RC-Glied über einen Inverter und zwei mit dessen Ausgang verbunden Feldeffekttransistoren komplementären Leitungstyps digitalisiert wird.

Es ist die Aufgabe der Erfindung, den Raum- und Flächenbedarf für das bekannte RC-Glied deutlich zu verringern und damit die Produktionskosten für Chips von kontaktlosen Chipkarten ebenfalls zu verringern.

Diese Aufgabe wird gelöst, mit einem Verfahren und einer Schaltungsanordnung zur Durchführung dieses Verfahrens, wobei ein mit einer Empfangseinrichtung empfangenes digitales amplitudenmodelliertes Funksignal mit einem Trägersignal und einem, diesem aufgeprägten digitalen Nachrichtensignal, in ein erstes und zweites Teilsignal aufgeteilt wird, wobei die beiden Teilsignale gleichsam positiv polarisiert oder negativ polarisiert sind und zueinander gegenphasig sind, und die beiden Teilsignale jeweils invertiert und mit "UND" verknüpft werden.

Mit diesem Verfahren wird ein RC-Glied zur Demodulation des empfangenen Signals durch die Und-Verknüpfung ersetzt. Somit erfolgt die Demodulation in der Und-Verknüpfung, wobei einem RC-Glied in der weiteren Signalverarbeitung ausschließlich eine das Signal glättende Aufgabe zufällt. Dazu ist das RC-glied entsprechend kleiner dimensionierbar.

Es werden bei der Demodulation durch die Und-Verknüpfung die jeweils positiven Halbwellen des empfangenen Funksignals zeitgleich an beiden Ausgängen der Empfangseinrichtung entnommen. Jedes dieser beiden Teilsignale wird für sich einem Inverter zugeführt. Dieser Inverter verändert das analoge Teilsignal aus positiven Halbwellen in ein digitales Rechtecksignal. Die Amplitude dieses Rechtecksignals nimmt dabei nur zwei Zustände, U=U_{MAX} oder U=U_{MIN}, an. Durch die Invertierung in dem Inverter ist das erhaltene Teilsignal zu dem ursprünglichem Teilsignal um 90 Grad phasenverschoben.

Ebenso wie die beiden Teilsignale des empfangenen Funksignals sind auch die, durch die Invertierung erhaltenen digitalen Teilsignale des Funksignals zueinander gegenphasig. Erfindungsgemäß sind die beiden Teilsignale einer Und-Verknüpfung zugeführt und dort "verundet".

Damit ergibt sich aus den phasenverschobenen Teilsignalen nach der "Verundung" eine digitale Null. Nur für empfangene Funksignale, deren Amplitude Null ist, ergibt sich nach der "Verundung" eine digitale Eins. Damit verbleibt am Ausgang der Und-Verknüpfung das digitale Nachrichtensignal. Dieses demodulierte digitale Nachrichtensignal wird einer Anordnung aus zwei Feldeffekttransistoren von komplementären Leitungstyp zugeleitet. Dies bewirkt eine Verstärkung des digitalen Signals.

Durch die erfindungsgemäße digitale und differentielle Demodulation des empfangenen Funksignals verbleiben geringe Störsignale von doppelter Frequenz des empfangenen Funksignals die das Nachrichtensignal überlagern. Diese sind von geringerer Amplitude. Diese Störsignale sind durch das bekannte RC-Glied herauszufiltern.

Durch die doppelte Frequenz dieser Störsignale und der geringen Amplitude, ist das kapazitive Glied des RC-Gliedes und auch das ohmsche Glied des RC-Gliedes deutlich geringer dimensionierbar.

Im folgenden ist die Erfindung anhand eines Ausführungsbeispiels unter Bezugnahme auf die Figuren näher beschrieben. Es zeigen:
Figur 1 eine Schaltungsanordnung zur Demodulation nach dem Stand der Technik,
Figur 2 eine Schaltungsanordnung zur Demodulation, die zumindest firmenintern bekannt ist und
Figur 3 eine erfindungsgemäße Schaltungsanordnung zur Demodulation.

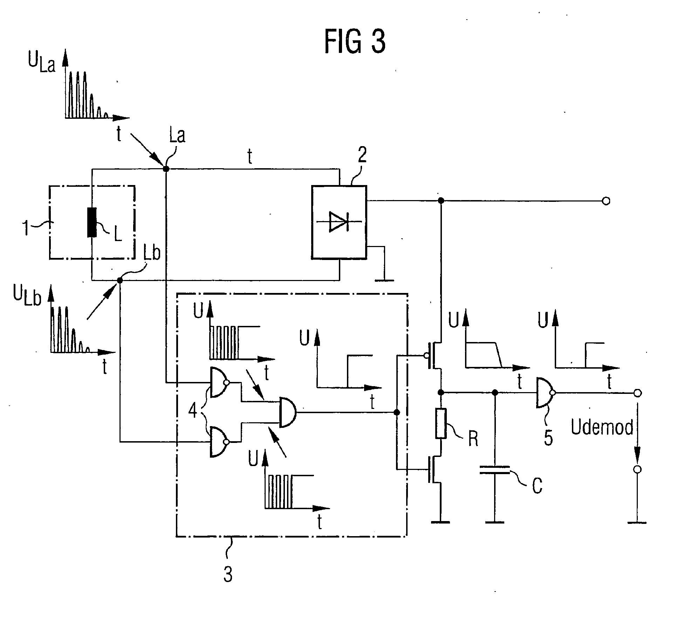

Die Schaltungsanordnung in Figur 3 enthält eine Empfangseinrichtung 1 mit einer Spule L, eine Gleichrichtungseinheit 2, eine Demodulationseinheit 3. In der Empfangseinheit 1 wird ein Funksignal von einer vorbestimmten Frequenz empfangen. Durch Induktion über das Funksignal an der Spule L entstehen an den beiden Ausgängen der Spule L bzw. der Empfangseinrichtung 1 La und Lb in Verbindung mit der Gleichrichtungseinheit 2 gegenphasige positiv polarisierte Halbwellen des Funksignals U_{La} und U_{Lb}. Die negativen Halbwellen des Funksignals sind dabei über die Gleichrichteeinheit 2 abgeschnitten.

Erfindungsgemäß werden beide Teilsignale U_{La} und U_{Lb,} jedes für sich, jeweils einem Inverter 4 zugeführt. In diesem Inverter 4 werden die jeweiligen analogen Teilsignale in digitale Rechtecksignale gleicher Frequenz umgewandelt, wobei jedoch auf Grund der Invertierung und Digitalisierung für Amplituden unter einer vorbestimmten Grenze eine digitale Null und für Amplituden über einer vorbestimmten Grenze eine digitale Eins gebildet wird.

Die beiden invertierten Signale werden einer Und-Verknüpfung zugeführt, wobei als Ergebnis am Ausgang der Und-Schaltung nur dann ein Signal eins anliegt, wenn die Amplitude U_{LA} und U_{LB} des eingehenden Funksignals einen bestimmten Wert unterschritten hat. Dieses Signal aus dem Ausgang der Und-Verknüpfung wird einer Anordnung von zwei Feldeffekttransistoren von komplementären Leitungstyp zugeführt. Damit erfolgt eine Verstärkung und Invertierung des am Ausgang der Und-Schaltung anliegenden Signals.

Das mit den Feldeffekttransistoren verbundene RC-Glied bewirkt eine Glättung der verbleibenden Störsignale, die mit geringerer Amplitude als das digitale Signal diesem überlagert sind. Die Störsignale haben dabei eine Frequenz von dem doppelten Betrag der Frequenz des empfangenen Funksignals, jedoch eine deutlich geringere Amplitude. Das RC-Glied ist somit deutlich kleiner dimensionierbar, als es für eine Demodulation des Funksignals erforderlich wäre. Mit einem, dem RC-Glied nachgeschalteten Inverter 5 wird das geglättete digitale Signal nochmals invertiert und die Flanken des digitalen Signals verbessert.

### Bezugszeichenliste

- 1: Empfangseinrichtung
- 2: Gleichrichtungseinheit
- 3: Demodulationseinheit
- 4: Inverter
- 5: Inverter
- L: Spule
- La: Ausgang A der Empfangseinrichtung
- Lb: Ausgang B der Empfangseinrichtung

## Patentansprüche

1. Verfahren zur Demodulation eines mit einer Empfangseinrichtung (1) empfangenen digitalen amplitudenmodulierten Funksignals mit einem Trägersignal und einem diesem aufgeprägten digitalen Nachrichtensignal,
**dadurch gekennzeichnet, dass**
das Funksignal in ein erstes und zweites Teilsignal (U_{La}/U_{Lb}) aufgeteilt wird, wobei die beiden Teilsignale gleichsam positiv polarisiert oder negativ polarisiert sind und zueinander gegenphasig sind, und die beiden Teilsignale jeweils invertiert und mit "UND" verknüpft werden.

2. Verfahren nach Patentanspruch 1,
**dadurch gekennzeichnet, daß**
der Empfang des Funksignals über induktive Kopplung erfolgt.

3. Verfahren nach einem der vorgenannten Patentansprüche,
**dadurch gekennzeichnet, daß**
es in kontaktlosen Chipkarten Anwendung findet.

4. Schaltungsanordnung zur Demodulation eines mit einer Empfangseinrichtung empfangenen digitalen amplitudenmodulierten Funksignals mit einem Trägersignal und einem diesem aufgeprägtem digitalen Nachrichtensignal,
**dadurch gekennzeichnet, dass**
- die Empfangseinrichtung (1) mit einer Gleichrichteeinheit (2) gekoppelt ist, wobei das Signal in zwei gegenphasige und gleichsam positiv oder negativ polarisierte Teilsignale aufgeteilt wird, und
- ein erster und ein zweiter digitaler Inverter jeweils mit einem Ausgang der Emfangseinrichtung verbunden ist und jeweils die beiden Teilsignale invertiert, und
- eine Und-Verknüpfung die beiden invertierten Teilsignale verknüpft.

5. Schaltungsanordnung nach Patentanspruch 4,
**dadurch gekennzeichnet, daß**
die Empfangseinrichtung (1) eine Spule ist.

6. Schaltungsanordnung nach Patentanspruch 4 bis 5,
**dadurch gekennzeichnet, daß**
ein Ausgang der Und-Verknüpfung mit einem ersten und zweiten Feldeffekttransistor von komplementären Leitungstyp verbunden ist.

7. Schaltungsanordnung nach Patentanspruch 4 bis 6,
**dadurch gekennzeichnet, daß**
diese in einer kontaktlosen Chipkarte angeordnet ist.

## Claims

1. Method for demodulating a digital amplitude-modulated radio signal, received using a reception device (1), having a carrier signal and a digital information signal impressed thereon,
**characterized in that**
the radio signal is split into a first and a second signal component (U_{LA}/U_{LB})_{,} where the two signal components have positive or negative polarization, as it were, and are in antiphase with respect to one another, and the two signal components are respectively inverted and "ANDed".

2. Method according to Patent Claim 1,
**characterized in that**
the radio signal is received by means of inductive coupling.

3. Method according to one of the preceding patent claims,
**characterized in that**
it is used in contactless chip cards.

4. Circuit arrangement for demodulating a digital amplitude-modulated radio signal, received using a reception device, having a carrier signal and a digital information signal impressed thereon,
**characterized in that**
- the reception device (1) is coupled to a rectification unit (2), with the signal being split into two signal components which are in antiphase and have positive or negative polarization, as it were, and
- a first and a second digital inverter are respectively connected to an output of the reception device and respectively invert the two signal components, and
- an AND function combines the two inverted signal components.

5. Circuit arrangement according to Patent Claim 4,
**characterized in that**,
the reception device (1) is a coil.

6. Circuit arrangement according to Patent Claims 4 to 5, **characterized in that**
an output of the AND function is connected to a first and a second field-effect transistor of complimentary conduction type.

7. Circuit arrangement according to Patent Claims 4 to 6,
**characterized in that**
this is arranged in a contactless chip card.

## Revendications

1. Procédé de démodulation d'un signal radio numérique modulé en amplitude, reçu par un dispositif (1) de réception et ayant un signal porteur et un signal numérique de message appliqué à celui-ci,
**caractérisé en ce que**
on subdivise le signal radio en un premier et en un deuxième sous-signal (U_{La}/U_{Lb}), les deux sous-signaux étant polarisés positivement ou polarisés négativement de la même façon et étant de phase opposée l'un à l'autre, et l'on inverse respectivement les deux sous-signaux et on les combine "ET".

2. Procédé suivant la revendication 1,
**caractérisé en ce qu'**on effectue la réception du signal radio par couplage inductif.

3. Procédé suivant l'une des revendications précédentes,
**caractérisé en ce qu'**il trouve à s'appliquer dans des cartes à puce sans contact.

4. Circuit de démodulation d'un signal radio numérique modulé en amplitude, reçu par un dispositif de réception et ayant un signal porteur et un signal numérique de message qui y est appliqué,
**caractérisé en ce que**
- le dispositif (1) de réception est couplé à une unité (2) de redressement, le signal est ensuite divisé en deux sous-signaux de phases opposées et polarisé positivement ou négativement de la même façon, et
- un premier et un deuxième inverseur numérique, reliés respectivement à une entrée du dispositif de réception et inversant respectivement les deux sous-signaux, et
- une combinaison logique ET qui combine les deux sous-signaux inversés.

5. Circuit suivant la revendication 4,
**caractérisé en ce que** le dispositif (1) de réception est une bobine.

6. Circuit suivant la revendication 4 à 5,
**caractérisé en ce qu'**une entrée de la combinaison logique ET est reliée à un premier et à un deuxième transistor à effet de champ du type de conductivité complémentaire.

7. Circuit suivant la revendication 4 à 6,
**caractérisé en ce qu'**il est disposé dans une carte à puce sans contact.
